(19) Europäisches Patentamt
European Patent Office
Office européen des brevets

(11) EP 3 035 062 A2

## (12) EUROPEAN PATENT APPLICATION

(43) Date of publication:
22.06.2016 Bulletin 2016/25

(51) Int Cl.:
$G01R\ 19/00$ (2006.01)    $G01R\ 35/00$ (2006.01)

(21) Application number: 15201400.7

(22) Date of filing: 18.12.2015

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 19.12.2014 US 201414576702

(71) Applicant: Keithley Instruments, Inc.
Cleveland OH 44139 (US)

(72) Inventor: RICE, Martin
Sagamore Hills, OH Ohio 44067 (US)

(74) Representative: Clarke, Jeffrey David
HGF Limited
Fountain Precinct
Balm Green
Sheffield S1 2JA (GB)

(54) METHOD FOR SELF CALIBRATION OF MEASUREMENT NONLINEARITY

(57) A method for calibrating a test instrument having an initial output voltage level and an open output relay can include programming the test instrument for a certain current level, starting a timer, and stopping the timer (responsive to the test instrument entering compliance) to determine a time interval. The method can also include determining whether the time interval is within a desired range.

FIG. 2

EP 3 035 062 A2

## Description

## Technical Field

This disclosure relates generally to various types of electronic instrumentation and, more particularly, to self-calibration of measurement circuitry therein.

## Background

Today's users of electronic instrumentation generally desire the measurement of either voltage or current to be highly linear over the range of the instrument (e.g., <<100ppm over the range). Also, linearity can - and often does - drift with time and temperature, which may necessitate frequent corrections. And removing the instrument to a calibration facility or requiring external equipment is particularly undesirable.

Today's users also tend to desire having an option of making faster measurements with correspondingly lower accuracy [or slower high-resolution measurements when called for] with the same instrument.

Accordingly, a need remains for improvement in electronic instrumentation that does not affect throughput for lower resolution, high speed measurements (which is usually the case with multipoint calibration). However, while certain designs (e.g., dual converters) may begin to address this problem, the shortcomings associated therewith include increased cost with regard to board space as well as further complications to calibration traceability.

## Summary

Embodiments of the disclosed technology generally pertain to techniques with regard to instrument self-adjustment for fixing the linearity of the measurement circuit without relying on external references or multipoint calibration. The instrument may be a test instrument (for example, an oscilloscope). The instrument may include one or more measurement circuits.

## Brief Description of the Drawings

FIGURE 1A illustrates an example of an ideal capacitance circuit.
FIGURE 1B illustrates an example of a non-ideal capacitance circuit.
FIGURE 1C is a graphical illustration of the voltage ramps corresponding to the ideal capacitance circuit and the non-ideal capacitance circuit illustrated by FIGURES 1A and 1B, respectively.
FIGURE 2 is a graphical illustration of the linearity self-adjust rejection of the dielectric absorption (DA) effect.
FIGURE 3 is a graphical illustration of an adjustment procedure in accordance with certain embodiments of the disclosed technology.

## Detailed Description

Embodiments of the disclosed technology may include calibration of DC accuracy in a conventional manner, e.g., a regular 3-point calibration that is done typically on an annual calibration cycle.

Certain implementations may be used to acquire a set of points (e.g., nine, roughly 1/8th of a scale apart) periodically (e.g., at the frequency chosen by the user, possibly on a monthly basis or more frequently if needed). These adjustment cardinal points may be taken during a, for example monthly, "calibration" cycle, and may then be used to adjust real-time measurements of the instruments during normal use. These adjustments may be stored in the instrument's data storage (e.g. non-volatile memory, such as flash memory), either alone, or along with, but separately from, the DC calibration constants.

When measurements are made that will benefit from further adjustment (e.g. 1 Power Line Cycle, PLC, or better), the linearity adjustment may be applied to the result (e.g., after DC calibration has already been applied).

Implementations may generally be performed without any external equipment or references by the user (e.g., customer). However, one potential issue with trying to self-calibrate linearity error is the lack of a reference. The instrument's source capability would seem to be a good choice: that is, simply sweeping the source across the range of the instrument then measuring the internal feedback network would yield information about the system linearity. Unfortunately, this technique also includes linearity errors of the source (e.g., the DAC) which is typically much worse than the measurement system that is in the process of being corrected.

Among the various advantages provided by certain implementations is that the instrument generally has a stable time reference (e.g., the processor clock). Also, the instrument generally includes a current sourcing capability that extends to a low level (e.g., nano-Amps). Further, a constant current into a pure capacitance generally yields a linear voltage-versus-time (i.e., $\Delta V/\Delta t = I/C$).

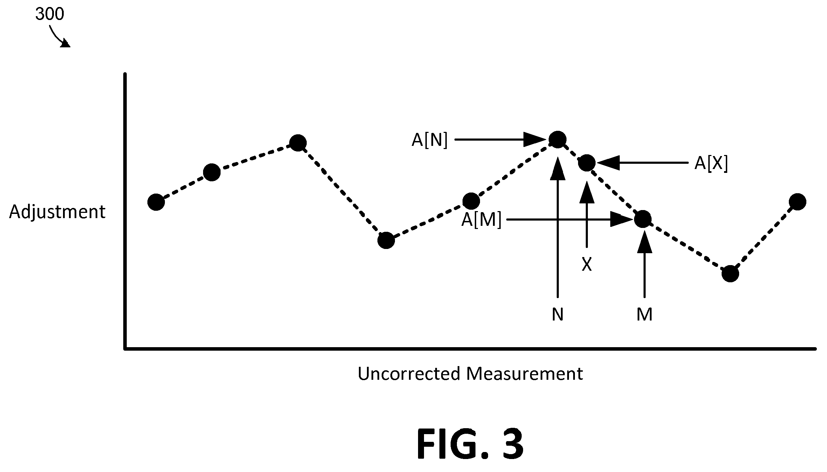

Embodiments may involve using the current source capability of the instrument into its own output capacitance to measure the cardinal points of the measurement circuit, which may advantageously eliminate source linearity from polluting the process because the source is not changing during the procedure. The current source may not need to be calibrated for this to work but there may be certain challenges. In some examples, the cardinal points are test (i.e. sample) points that may be arbitrarily selected in some organized manner, according to the rate or number of test points desired, and may be equally or variably spaced. For example, if a 10 volt range were sampled at every 0.5 Volts, then there would be 21 cardinal points including 0V and 10V. In the example used herein, there are nine sampled points (i.e. nine cardinal points), as shown in Figure 3, noting point X is not a sampled cardinal point, but is a real-time measurement to be adjusted at a later stage.

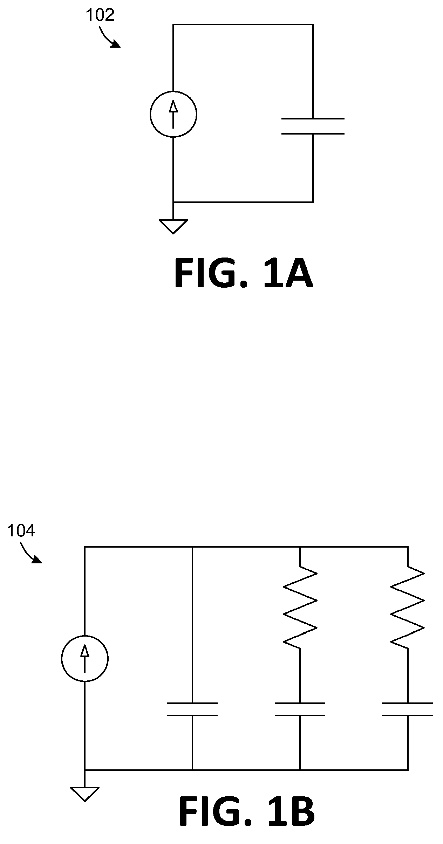

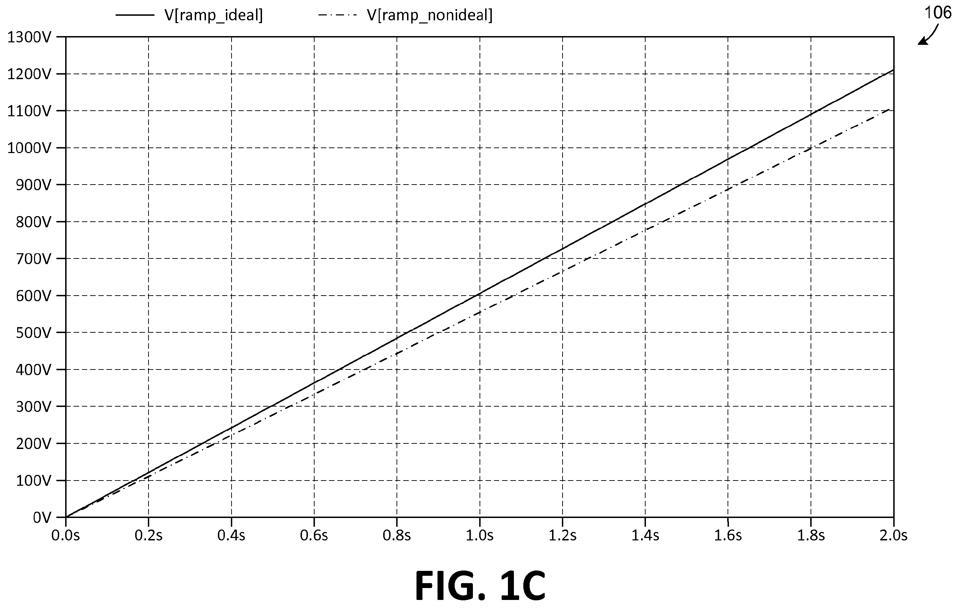

As used herein, Dielectric Absorption (DA) generally refers to the non-ideal way that the output capacitance of a circuit (e.g. a measurement circuit in a test instrument) behaves due to the absorption of charge through materials that have a high relative permittivity (e.g., with respect to air). These dielectrics can be part of the capacitors themselves or the printed circuit board (PCB) on which the capacitor is soldered, where the capacitors and/or PCBs may form at least a portion of a circuit, such as a measurement circuit of a test instrument. DA may be modeled as a series of parasitic elements in parallel with the ideal capacitance that is charging. FIGURE 1A illustrates an example of an ideal capacitance circuit 102, FIGURE 1 B illustrates an example of a non-ideal capacitance circuit 104, and FIGURE 1C is a graphical illustration 106 of the voltage ramps corresponding to the ideal capacitance circuit 102 and the non-ideal capacitance circuit 104.

No matter the cause, the effect of DA is generally to make the voltage ramp during constant-current output not linear, frustrating efforts to obtain linearity information about the measurement circuits. Another source of error that may benefit from correction is integral nonlinearity (INL) by A/D converters or amplifiers within the test instrument, for example.

However, nonlinearity due to DA or INL has been observed to be symmetrical with respect to the direction of current flow. That is, if the current ramp is repeated at the same rate and opposite polarity, the differential voltage measured across the effective output impedance will largely discard nonlinearities that are due to DA while maintaining the nonlinearity due to the measurement circuit.

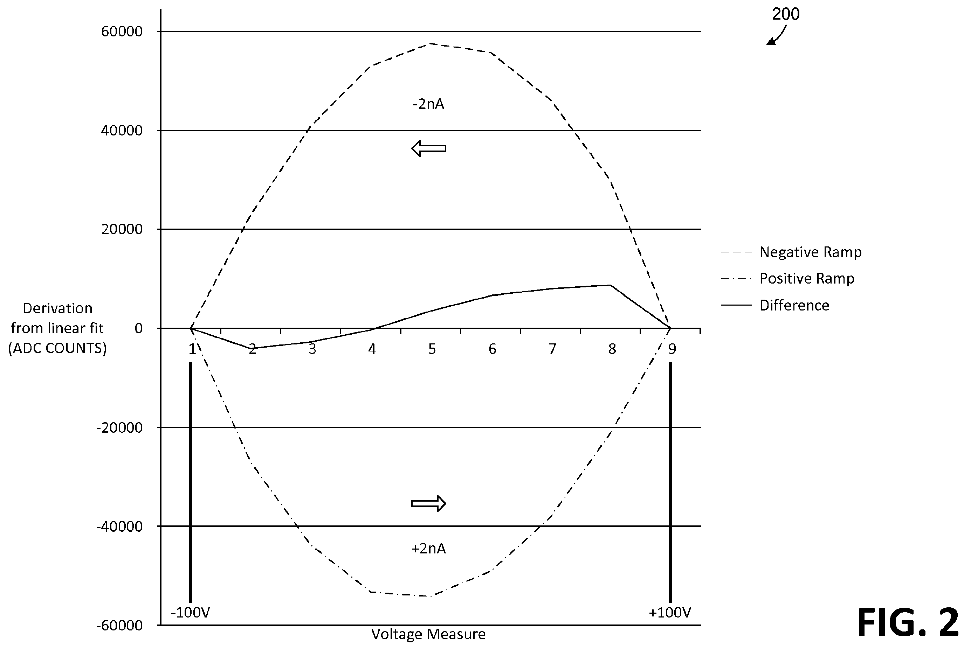

FIGURE 2 is a graphical illustration 200 of the linearity self-adjust rejection of the DA effect. The output capacitance and current source accuracy are both typically highly variable. That is, the ramp rate seen by the measurement circuit may vary significantly. For self-calibration to be effective, the nine cardinal points in the graph 200 need to be approximately evenly spaced from negative (-) full scale to positive (+) full scale. To accomplish this, the self-calibration algorithm may include a timing phase at the beginning.

The algorithm may begin with the output at 0V and the output relay of the instrument open. The instrument may then be programmed to provide a small negative current (e.g., approx. -2nA), and a timer may begin. Once the instrument reaches a certain voltage limit, the timer may be stopped. If the time measured is outside the range desired for the procedure (which is typically determined by the DA issue and the speed of the instrument's acquisition) then the instrument output may be reset to 0V and the current level may be adjusted. This may be repeated as necessary.

Once the current level has been adjusted and the timing is known, the instrument may perform two sweeps. Firstly, beginning at the negative (-) full scale (i.e., -100V in the example), the current source may be programmed for the chosen level, with positive polarity. The instrument firmware may measure the voltage at the time interval identified, for example resulting in nine cardinal points.

Secondly, now at the positive (+) full scale (i.e., +100V in the example), the current source polarity may be reversed and the same - or comparable - procedure may be used to acquire nine more cardinal points. The second array may be reversed and then subtracted from the first. The resulting array of cardinal points may be used to extract a linearity factor for the measurement circuit (e.g., meaning that the array is "linearized" by subtracting it from an ideal straight line which begins at a first point and ends at a second point). In some examples, the first point may be a first (i.e. earlier) cardinal point, and the second point may be a next (i.e. later) cardinal point, i.e. the linearization is carried out per cardinal point grouping. In some other examples, the first point may be the first cardinal point and the second point may be the last cardinal point, e.g. the ninth cardinal point in the example of Figure 3.

Once the coefficients for linearity adjustment have been acquired, they may be stored for future use. In certain implementations, application of the linearity adjustment may take approximately 15 microseconds, so it would typically only be applied to measurements where the throughput is significantly slower so that higher speed (e.g., lower resolution) measurements are not negatively impacted. For example, a 1 PLC equivalent reading generally requires 16.6 milliseconds to acquire, effectively rendering irrelevant the overhead of linearity adjustment.

FIGURE 3 is a graphical illustration 300 of an adjustment procedure in accordance with certain embodiments of the disclosed technology. The measurement to be adjusted is typically bounded by two of the available adjustment points (i.e. cardinal points, e.g., which may occur at approximately 1/8th scale intervals in an example with nine cardinal points). Given that the real-time measurement (X) in the example is between two adjustment cardinal points M and N, which have corresponding adjustment values A[M] and A[N] (e.g., the amount of nonlinearity known at those points), the adjusted measurement (Y) may be calculated by linear interpolation between the two cardinal points bounding the measurement using the following:

$$A_X = A_N + \left(A_M - A_N\right) \cdot \frac{X-N}{M-N}$$

and

$$Y = X + A_X.$$

It should be noted that the calibration procedure according to the present disclosure does not rely on taking nine cardinal points and may work effectively with fewer cardinal points in certain situations or require more cardinal points in other situations. The number of cardinal points needed generally depends on the nature of the nonlinearity being corrected.

The techniques described herein may also be used to adjust current measure linearity if resources are available to route the voltage measurement information to the current measurement circuit.

The following discussion is intended to provide a brief, general description of a suitable machine in which embodiments of the disclosed technology can be implemented. As used herein, the term "machine" is intended to broadly encompass a single machine or a system of communicatively coupled machines or devices operating together. Exemplary machines may include computing devices such as personal computers, workstations, servers, portable computers, handheld devices, tablet devices, and the like. Exemplary machines may also include test instruments, such as an oscilloscope, and the like.

Typically, a machine includes a system bus to which processors, memory such as random access memory (RAM), read-only memory (ROM), and other state-preserving medium, storage devices, a video interface, and input/output interface ports can be attached. The machine may also include embedded controllers such as programmable or non-programmable logic devices or arrays, Application Specific Integrated Circuits (ASICs), embedded computers, smart cards, and the like. The machine may be controlled, at least in part, by input from conventional input devices such as keyboards and mice, as well as by directives received from another machine, interaction with a virtual reality (VR) environment, biometric feedback, or other pertinent input.

The machine may utilize one or more connections to one or more remote machines, such as through a network interface, modem, or other communicative coupling. Machines can be interconnected by way of a physical and/or logical network, such as an intranet, the Internet, local area networks, wide area networks, etc. One having ordinary skill in the art will appreciate that network communication may utilize various wired and/or wireless short range or long range carriers and protocols, including radio frequency (RF), satellite, microwave, Institute of Electrical and Electronics Engineers (IEEE) 545.11, Bluetooth, optical, infrared, cable, laser, etc.

Examples provide a method for calibrating a test instrument having an initial output voltage level and an open output relay, comprising programming the test instrument for a certain current level, starting a timer, responsive to the test instrument entering compliance, stopping the timer to determine an initial time interval,

and determining whether the initial time interval is within a desired range. In some examples, compliance is when the test instrument reaches a certain, i.e. predetermined, voltage level.

Some examples further comprise resetting the instrument output to the initial output voltage level, adjusting the certain current level, repeating the starting and stopping of the timer to determine a subsequent time interval, and determining whether the subsequent time interval is within the desired range.

In some examples the initial output voltage is 0 Volts.

In some examples the certain current level is -2nA.

Some examples further comprise, beginning at a negative (-) full scale, programming a current source for the certain current level, measuring the voltage level at the initial time interval, and identifying a first array of cardinal points based on the measuring.

Some examples further comprise, beginning at a positive (+) full scale, reversing the polarity of the current source, measuring the voltage level at the initial time interval, and identifying a second array of cardinal points based on the measuring.

Some examples further comprise reversing the second array, subtracting the second array from the first array to create a resulting array, and extracting a linearity factor from the resulting array.

Some examples further comprise storing the linearity factor for later use.

Examples also include test instruments arranged to carry out any disclosed method. For example, a test instrument comprising one or more processors that may execute instructions that when executed cause the test instrument to carry out a disclosed method of calibration.

Examples also provide a computer readable medium comprising instructions, which, when executed by one or more processors, causes the processors to carry out any of the disclosed calibration methods.

Having described and illustrated the principles of the invention with reference to illustrated embodiments, it will be recognized that the illustrated embodiments may be modified in arrangement and detail without departing from such principles, and may be combined in any desired manner. And although the foregoing discussion has focused on particular embodiments, other configurations are contemplated.

In particular, even though expressions such as "according to an embodiment of the invention" or the like are used herein, these phrases are meant to generally reference embodiment possibilities, and are not intended to limit the invention to particular embodiment configurations. As used herein, these terms may reference the same or different embodiments that are combinable into other embodiments.

Consequently, in view of the wide variety of permutations to the embodiments that are described herein, this detailed description and accompanying material is intended to be illustrative only, and should not be taken as limiting the scope of the invention. What is claimed as the invention, therefore, is all such modifications as may come within the scope of the following claims and equivalents thereto.

**Claims**

1. A method for calibrating a test instrument having an initial output voltage level and an open output relay, comprising:

   programming the test instrument to provide a certain current level;
   starting a timer;
   responsive to the test instrument entering compliance, stopping the timer to determine an initial time interval; and
   determining whether the initial time interval is within a desired range.

2. The method of claim 1, further comprising:

   resetting the instrument output to the initial output voltage level;
   adjusting the certain current level;
   repeating the starting and stopping of the timer to determine a subsequent time interval; and
   determining whether the subsequent time interval is within the desired range.

3. The method of any previous claim, in which the initial output voltage is 0 Volts.

4. The method of any previous claim, in which the certain current level is - 2nA.

5. The method of any previous claim, further comprising:

   beginning at a negative (-) full scale, programming a current source for the certain current level;
   measuring the voltage level at the initial time interval; and
   identifying a first array of cardinal points based on the measuring.

6. The method of any previous claim, further comprising:

   beginning at a positive (+) full scale, reversing the polarity of the current source;
   measuring the voltage level at the initial time interval; and
   identifying a second array of cardinal points based on the measuring.

7. The method of any previous claim, further comprising:

   reversing the second array;
   subtracting the second array from the first array to create a resulting array; and
   extracting a linearity factor from the resulting array.

8. The method of any previous claim, further comprising storing the linearity factor for later use.

9. A computer readable medium comprising instructions, which, when executed by one or more processors, causes the processors to carry out the method of any of claims 1 to 8.

10. A test instrument arranged to carry out any of method claims 1 to 8.

102

**FIG. 1A**

104

**FIG. 1B**

**FIG. 1C**

EP 3 035 062 A2

EP 3 035 062 A2

**FIG. 2**

FIG. 3